# EUROPEAN PATENT SPECIFICATION

(11) **EP 1 469 355 B1**
(45) Date of publication and mention of the grant of the patent: **20.08.2008**
(21) Application number: 03258052.4
(22) Date of filing: 19.12.2003
(51) Int. Cl.: G03F 9/00

(54) **Device manufacturing method**
Verfahren zur Herstellung einer Vorrichtung
Méthode de fabrication d'un dispositif

(30) Priority: 20.12.2002 EP 02258834
(43) Date of publication of application: 20.10.2004
(73) Proprietor: ASML Netherlands B.V., 5504 DR Veldhoven (NL)
(72) Inventor: Best, Keith Frank, Prunedale, CA 93907 (US); Consolini, Joseph J., Costa Mesa, CA 92626 (US); Shinde, Shyam, Fremont, CA 94539 (US)
(74) Representative: Leeming, John Gerard

(56) References cited:
- EP-A- 1 081 748
- US-A- 4 818 724
- US-A- 5 004 705

## Description

The present invention relates to a device manufacturing method using lithographic apparatus.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

Alignment is the process of positioning the image of a specific point on the mask to a specific point on the wafer which is to be exposed. Typically one or more alignment marks, such as a small pattern, are provided on each of the substrate and the mask. A device may consist of many layers which are built up by successive exposures with intermediate processing steps. Before each exposure, alignment between the markers on the substrate and the mask is performed to minimize any positional error between the new exposure and the previous ones, which error is termed overlay error.

For some devices, e.g. micro-electro-mechanical systems (MEMS) and micro-opto-electro-mechanical systems (MOEMS), it is desirable to be able to create structures on both sides of a substrate using lithographic processes and in many cases, the structures on opposite sides of the substrate need to be aligned with each other. This means that it is necessary for the lithographic apparatus to align the pattern being projected onto the frontside of a substrate to alignment markers on the backside. Known methods to do this use optics to project an image of a backside marker to the front side of the substrate or an alignment tool that uses a wavelength to which the substrate is transparent. However, in some circumstances it is desirable to bond the substrate first side down to a carrier (or handle) wafer in order to print the second side. In that case, front-to-backside optics are of no use. Also, whilst a silicon substrate is transparent to infrared radiation, alignment using such radiation has limited accuracy and may undesirably heat the wafer.

It has been proposed, e.g. in EP-A-1 081 748 and US 5,004,705, to etch trenches deeply into a wafer before it is flipped and bonded to a carrier. The wafer is then etched to reveal the trenches which are used for crude alignment of exposures on the topside.

EP 1 081 748 A2 discloses a method of making a bonded wafer comprising the following steps. Trenches are etched a predetermined distance into the first wafer from the first major surface toward a second major surface. The first major surface and trenches are coated with oxide. The first major surface of the first wafer is bonded to a second wafer to form a bonded wafer. The second major surface of the bonded wafer which is also the second major surface of the first wafer is ablated until oxide in the trenches is detected.

US-A-5,004,705 discloses a process for fabricating a semiconducted device by forming a diffusion region in a first semiconductor wafer and bonding the surface of the first semiconductor wafer having the diffused region to a second semiconductor wafer. A recess may be made into the wafer before bonding which would be exposed after thinning of the substrate and used to align to other structures.

US-A-5,818,724 discloses a method comprising using photolithography to align a predetermined structure on the rear of a sample taking as reference circuit elements produced on the front. The disclosed technique utilises a template with respect to which the substrate is aligned and to which the substrate is bonded.

It is an object of the present invention to provide a device manufacturing method which can print structures on one side of a substrate aligned to markers on the other side when the substrate is bonded to a carrier and with improved accuracy.

According to an aspect of the invention, there is provided a device manufacturing method according to claim 1.

The alignment maker formed in the first surface is revealed by the etch as a normally oriented alignment marker to which the lithographic projection apparatus can readily align. Patterns directly aligned to the marker printed on the frontside can therefore be printed on the backside of the substrate. The standard alignment pattern is one to which an alignment tool in the lithographic apparatus used for imaging can align. It may be, for example, a group of gratings of different orientations and pitches. Other patterns may also be used.

The present invention thus avoids the need for an additional step of printing alignment markers on the second surface of the substrate prior to the formation of process layers.

The alignment marker comprising the mirror image of the alignment pattern may also comprise a normal image of said alignment pattern overlaid on the mirror image. This produces a single alignment marker that can be aligned to during exposures on both sides of the substrate ensuring alignment between structures on the two sides. In the case of an alignment mark comprising a group of gratings, this turns the linear gratings into grids. Before the substrate is bonded to the second (carrier) substrate, devices may be formed in and/or on the first surface using known techniques.

Normal alignment markers for use in aligning the structures in or on the first surface can be printed in the same step as the reverse alignment markers used to align the structures formed on the second surface. In this way, the positional relationship of the normal and reversed markers and hence of the structures on the first and second surfaces can be assured.

The reduction in thickness may be effected by lapping or grinding.

The first depth may be of the order of 10µm or more and the first thickness may be of the order of 10µm or less.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
- Figure 1 depicts a lithographic projection apparatus which can be used in the method of the invention;
- Figure 2 is a plan view of a substrate showing the location of alignment markers used in the method of the invention; and
- Figures 3 to 5 depict normal, reversed and combined alignment markers respectively; and
- Figures 6 to 8 illustrate steps in a method of manufacturing devices according to the invention.

### Lithographic Projection Apparatus

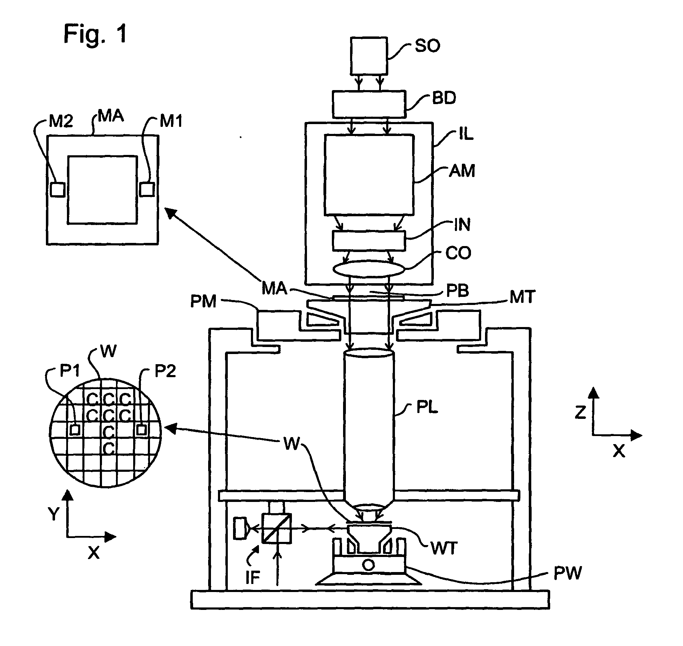

Figure 1 schematically depicts a lithographic projection apparatus which can be used to perform steps of the method of the invention. The apparatus comprises:
- an illumination system (illuminator) IL for providing a projection beam PB of radiation (e.g. UV radiation or DUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

### Embodiment 1

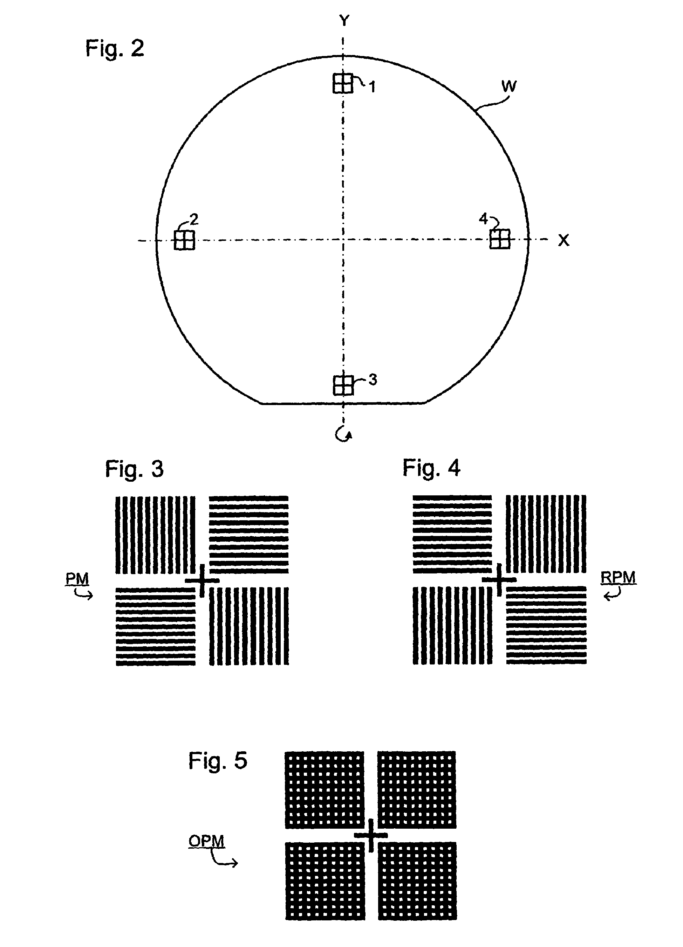

Figure 2 shows a wafer W which is to be provided with devices on both sides and on which are provided normal markers (not shown) and reversed markers 1-4. The reversed markers 1-4 are mirror images - about the axis about which the wafer is to be rotated, in this case the Y axis - of the normal markers. The normal markers may take any convenient form, such as a grating, a group of gratings, box-in-box, frame-in-frame, chevrons, etc., as known in the art, and may form the primary markers used for global alignment of the substrate prior to a series of exposures. In the present example the markers are provided at symmetrical positions on the wafer axes. The present invention may of course also be applied to other markers, e.g. markers adjacent each target area or die.

In Figure 3, an example of a normal marker PM is shown - this comprises a group of four gratings. Of the four gratings, a pair are horizontal and a pair vertical and, though not apparent from the drawing, the two gratings of each pair have different periods in a known manner. Figure 4 shows the corresponding reversed marker RPM which has the same four gratings but in a mirror image arrangement. The combined marker OPM is shown in Figure 5 - as can be seen, the one-dimensional gratings become two-dimensional gratings or grids.

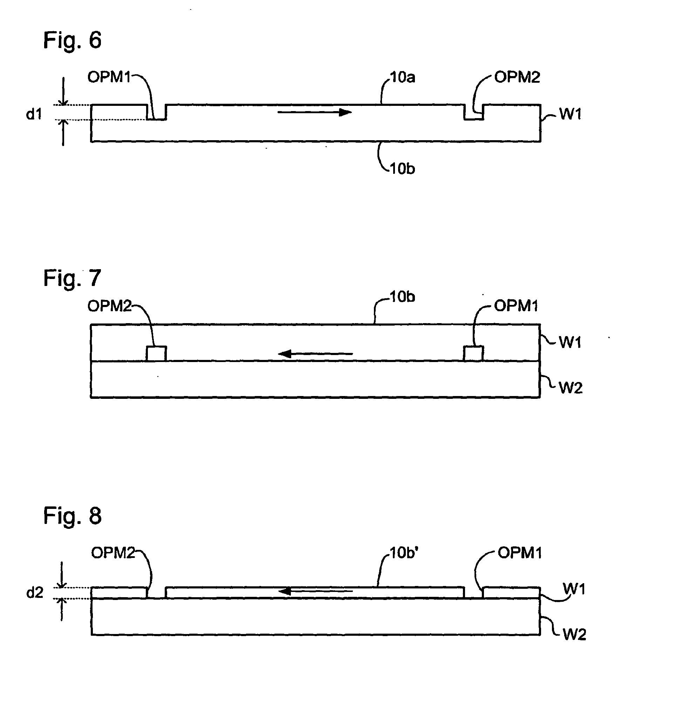

Figures 6 to 8 illustrate steps in an example of the method of the invention. Firstly, normal markers (not shown) and reversed markers OPM1, OPM2 are etched into first surface 10a of substrate W1 in a known manner to a depth d1 of 10µm or more. Exposures and other process steps to form desired devices on the first surface are then performed. The substrate W1 is then flipped over and bonded to carrier substrate W2 with a layer of adhesive. Figure 7 shows the substrate W bonded to the carrier substrate CW, with the second surface 10b uppermost.

As shown in Figure 8, the wafer W is ground or lapped to a desired thickness, d2, e.g. of about 10µm or less, and the upper surface 10b' finished as required for the devices to be formed on it. At this stage, the reversed markers 1-4, which were etched to a depth of 10µm or more into the first surface are revealed in the second surface and can be aligned to in a known manner.

Suitable alignment systems and processes which can be used to align to the revealed reversed markers are described in WO 98/39689, which document is incorporated herein by reference.

If the combined marker shown in Figure 5 is used, alignment to it can be performed from both sides of the substrate ensuring direct alignment of structures on opposite sides of the substrates, without the need for offsets.

While specific embodiments of the invention have been described above, it will be appreciated that the invention may be practiced otherwise than as described. The description is not intended to limit the invention.

## Claims

1. A device manufacturing method comprising the steps of:
providing a first substrate (W1) having first and second surfaces (10a, 10b);
etching said first surface (10a) of said first substrate (W1) to a first depth with at least one alignment marker (OPM1, OPM2), said alignment marker (OPM1, OPM2) comprising a mirror image of a standard alignment pattern;
bonding said first surface (10a) of said first substrate (W1) to a second substrate (W2); and
thinning said first substrate (W1) to a first thickness equal to or less than said first depth thereby revealing said alignment marker (OPM1, OPM2);
**characterised by**
forming at least one patterned layer on said second surface (10b) using a lithographic projection apparatus after aligning said first substrate (W1) using the revealed alignment marke(s)(OPM1, OPM2).

2. A method according to claim 1, wherein said alignment marker (OPM1, OPM2) further comprises a normal image of said standard alignment pattern overlaid on said mirror image.

3. A method according to claim 1 or 2, wherein said alignment pattern comprises a set of 1-dimensional gratings.

4. A method according to claim 1, 2 or 3, wherein said first depth is 10µm or more and said first thickness is 10µm or less.

5. A method according to claim 1, 2, 3 or 4, wherein said step of thinning said first substrate (W1) comprises lapping or grinding.

6. A method according to any one of the preceding claims comprising the further step before said step of bonding, of forming devices in and/or on the first surface (10a).

7. A method according to any one of the preceding claims, wherein said alignment marker(s) (OPM1, OPM2) is(are) patterned using the same apparatus as is used for patterning the process layers.

8. A method according to any one of the preceding claims, wherein said step of forming at least one patterned layer on said second surface (10b) includes the formation of at least one further alignment marker at a known position relative to the revealed alignment marker(s).

## Patentansprüche

1. Verfahren zur Herstellung eines Bauteils, das folgende Schritte umfasst:
• Bereitstellen eines ersten Substrats (W1), das erste und zweite Oberflächen (10a, 10b) aufweist;
• Ätzen der ersten Oberfläche (10a) des ersten Substrats (W1) auf eine erste Tiefe mit wenigstens einer Ausrichtungsmarkierung (OPM1, OPM2), wobei die Ausrichtungsmarkierung (OPM1, OPM2) ein Spiegelbild eines StandardAusrichtungsmusters umfasst;
• Bonden der ersten Oberfläche (10a) des ersten Substrats (W1) an ein zweites Substrat (W2); und
• Dünnen des ersten Substrats (W1) auf eine erste Dicke, die der ersten Tiefe gleich oder kleiner als diese ist, wodurch die Ausrichtungsmarkierung (OPM1, OPM2) freigelegt wird;
**gekennzeichnet durch**
Bilden von wenigstens einer gemusterten Schicht auf der zweiten Oberfläche (10b) unter Verwendung einer lithographischen Projektionsvorrichtung nach der Ausrichtung des ersten Substrats (W1) unter Verwendung der freigelegten Ausrichtungsmarkierung(en) (OPM1, OPM2).

2. Verfahren nach Anspruch 1, wobei die Ausrichtungsmarkierung (OPM1, OPM2) ferner eine normale Abbildung des Standardausrichtungsmusters überlagert auf das Spiegelbild umfasst.

3. Verfahren nach Anspruch 1 oder 2, wobei das Ausrichtungsmuster einen Satz eindimensionaler Gitter umfasst.

4. Verfahren nach Anspruch 1, 2 oder 3, wobei die erste Tiefe 10µm oder mehr und die erste Dicke 10µm oder weniger beträgt.

5. Verfahren nach Anspruch 1, 2, 3 oder 4, wobei der Schritt des Dünnens des ersten Substrats (W1) Läppen oder Schleifen umfasst.

6. Verfahren nach einem der vorhergehenden Ansprüche, das den weiteren Schritt umfasst, dass vor dem Schritt des Bondens Bauteile in und/oder auf der ersten Oberfläche (10a) gebildet werden.

7. Verfahren nach einem der vorhergehenden Ansprüche, wobei die Ausrichtungsmarkierung(en) (OPM1, OPM2) unter Verwendung der gleichen Vorrichtung gemustert wird (werden), wie sie zum Mustern der Verfahrensschichten verwendet wird.

8. Verfahren nach einem der vorhergehenden Ansprüche, wobei der Schritt des Bildens von wenigstens einer gemusterten Schicht auf der zweiten Oberfläche (10b) die Bildung von wenigstens einer weiteren Ausrichtungsmarkierung bei einer bekannten Position relativ zu der (den) freigelegten Ausrichtungsmarkierung(en) umfasst.

## Revendications

1. Procédé de fabrication d'un dispositif comprenant les étapes suivantes :
fournir un premier substrat (W1) ayant des première et seconde surfaces (10a, 10b) ;
graver ladite première surface (10a) dudit premier substrat (W1) jusqu'à une première profondeur avec au moins un marqueur d'alignement (OPM1, OPM2), ledit marqueur d'alignement (OPM1, OPM2) comprenant une image inversée d'un motif d'alignement standard ;
coller ladite première surface (10a) dudit premier substrat (W1) à un second substrat (W2) ; et
amincir ledit premier substrat (W1) jusqu'à une première épaisseur égale ou inférieure à ladite première profondeur en révélant ainsi ledit marqueur d'alignement (OPM1, OPM2) ;
**caractérisé par**
la formation d'au moins une couche mise en forme sur ladite seconde surface (10b) en utilisant un appareil de projection lithographique après alignement dudit premier substrat (W1) en utilisant le(s) marqueur(s) d'alignement révélé(s) (OPM1, OPM2).

2. Procédé selon la revendication 1, dans lequel ledit marqueur d'alignement (OPM1, OPM2) comprend en outre une image normale dudit motif d'alignement standard superposé sur ladite image inversée.

3. Procédé selon la revendication 1 ou 2, dans lequel ledit motif d'alignement comprend un ensemble de réseaux unidimensionnels.

4. Procédé selon la revendication 1, 2 ou 3, dans lequel ladite première profondeur est de 10 µm ou plus et ladite première épaisseur est de 10 µm ou moins.

5. Procédé selon la revendication 1, 2, 3 ou 4, dans lequel ladite étape d'amincissement dudit premier substrat (W1) comprend un rodage ou un meulage.

6. Procédé selon l'une quelconque des revendications précédentes, comprenant l'étape supplémentaire avant ladite étape de collage, de formation de dispositifs dans et/ou sur la première surface (10a).

7. Procédé selon l'une quelconque des revendications précédentes, dans lequel ledit (lesdits) marqueur(s) d'alignement (OPM1, OPM2) est (sont) mis en forme en utilisant le même appareil que celui utilisé pour mettre en forme les couches de traitement.

8. Procédé selon l'une quelconque des revendications précédentes, dans lequel ladite étape de formation d'au moins une couche mise en forme sur ladite seconde surface (10b) inclut la formation d'au moins un marqueur d'alignement supplémentaire dans une position connue par rapport au(x) marqueur(s) d'alignement révélé(s).
